(19)

Europäisches Patentamt
European Patent Office
Office européen des brevets

(11) Veröffentlichungsnummer: **0 061 142**
**A2**

(12) **EUROPÄISCHE PATENTANMELDUNG**

(21) Anmeldenummer: 82102167.2

(22) Anmeldetag: 17.03.82

(51) Int. Cl.³: **G 01 D 13/00**
G 01 R 13/00

(30) Priorität: 19.03.81 DE 3110671

(43) Veröffentlichungstag der Anmeldung: 29.09.82 Patentblatt 82/39

(84) Benannte Vertragsstaaten: AT BE CH DE FR GB IT LI LU NL SE

(71) Anmelder: Johnson Service Company
5757 North Green Bay Avenue
Milwaukee Wisconsin(US)

(72) Erfinder: Schmidt, Jörg
Wiesbadener Strasse 24
D-4300 Essen(DE)

(74) Vertreter: PATENTANWÄLTE HENKEL - KERN - FEILER - HÄNZEL
Möhlstrasse 37
D-8000 München 80(DE)

(54) **Analoge Ausgangssignalanzeige.**

(57) Die Erfindung betrifft eine analoge Ausgangssignalanzeige unter Verwendung von zwei nebeneinander angeordneten Leuchtdioden, die gegenläufig geschaltet sind und von der Ausgangssignalspannung gesteuert werden.

Die Anzeige erfolgt so, daß bei Anliegen von O-Ausgangssiganlspannung die eine Leuchtdiode LD1 ihre größte Leuchtstärke aufweist und die andere Leuchtdiode nicht aufleuchtet; bei Anliegen von 50% der Ausgangssignalspannung leuchten beide Leuchtidioden LD1 und LD2 mit einer mittleren Leuchtstärke, und bei Anliegen von 100% der Ausgangssignalspannung leuchtet die erste Leuchtdiode LD1 nicht auf, aber die zweite Leuchtdiode LD2 dagegen mit ihrer größten Leuchtstärke.

Bei Anliegen von etwa 25% der Ausgangssignalspannung leuchtet die Leuchtdiode LD1 heller als die Leuchtdiode LD2, und bei Anliegen von 75% der Ausgangssignalspannung leuchtet die Leuchtdiode LD2 heller als die Leuchtdiode LD1.

Durch diese Anzeige wird das Abschätzen der am Ausgang anliegenden Signalspannung wesentlich erleichtert.

Leucht-
stärke
100%
ca.50%
0
LD1
LD2
0
50%
100%
Ausgangssignal

Fig.1

EP 0 061 142 A2

Analoge Ausgangssignalanzeige

Die Erfindung betrifft eine analoge Ausgangssignalanzeige, insbesondere für Regler, unter Verwendung von Leuchtdioden.

In der Praxis wird bei technischen Geräten, z.B. bei Stellungsanzeigen oder dergleichen, die Höhe des am Ausgang eines Verstärkers anliegenden Signales entweder mit einem Drehspulinstrument oder mit einer bzw. zwei parallel geschalteten Leuchtdioden angezeigt.

Da die Verwendung eines Drehspulinstrumentes zur Anzeige des Ist-Zustandes eines Ausgangssignals sehr teuer ist und Drehspulinstrumente nicht robust genug sind, um, eingesetzt in einen Regler, der Lebensdauererwartung zu entsprechen, wird häufig die Anzeige des Ausgangssignals mit einer oder mit zwei parallel geschalteten Leuchtdioden bevorzugt.

Der Nachteil dieser herkömmlichen Anzeige besteht jedoch darin, daß die Anzeige der Höhe des Ausgangssignals nicht differenziert genug ist, so daß man von der während der Anzeige sich nur wenig ändernden Leuchtstärke der Leuchtdioden nur sehr schlecht auf die Größe der am Ausgang eines Verstärkers anliegenden Signalspannung schließen kann. Dies geht am ehesten vielleicht noch in den Endbereichen, d.h. Anliegen keines Ausgangssignals oder Anliegen des vollen Ausgangssignals, aber keinesfalls kann man Zwischenwerte bestimmen bzw. ablesen. Selbst bei Anliegen des vollen Ausgangssignals ist kein genügend großes Kriterium für eine Aussage vorhanden.

Der Erfindung liegt deshalb die Aufgabe zugrunde, eine unkomplizierte Anzeige des Ausgangssignals mit Leuchtdioden zu schaffen, die zwischen den verschiedenen Ausgangssignalwerten gut differenziert ist, so daß für das Bedienungs- oder Wartungspersonal an der unterschiedlichen Leuchtstärke zwischen diesen beiden Dioden die dieser Leuchtstärke zugeordneten 0%, 50% oder 100% der Ausgangssignalwerte sowie die Abschätzung der dazwischenliegenden Werte leichter und genauer erkennbar ist.

Die Lösung dieser Aufgabe wird durch die im kennzeichnenden Teil des Anspruches 1 angegebenen Maßnahmen erreicht.

Im Anspruch 2 ist die sich daraus ergebende tatsächliche Anzeige der Ausgangssignalwerte angegeben.

Die erfindungsgemäße Anzeige der Ausgangssignalwerte durch Leuchtdioden läßt durch größere Unterschiede in der Leuchtstärke der Leuchtdioden eine bessere Abschätzung des Ist-Signalwertes zu, als dies bei den herkömmlichen Anzeigen möglich ist, so daß eine Fehlschätzung des Ist-Ausgangssignals aufgrund der Leuchtdiodenanzeige praktisch nicht mehr vorkommt.

Die Erfindung wird anhand eines Beispiels beschrieben. In den Zeichnungen zeigt:

Fig. 1 ein Diagramm, aus dem die Abhängigkeit der Leuchtstärke der beiden Leuchtdioden von dem anliegenden Ausgangssignal hervorgeht,

Fig. 2 eine Prinzipdarstellung der Anordnung der beiden Leuchtdioden in einem Gerät mit darüber angeordnetem Schwellpfeil

Fig. 3 eine Schaltungsanordnung der beiden Leuchtdioden in einem Gerät.

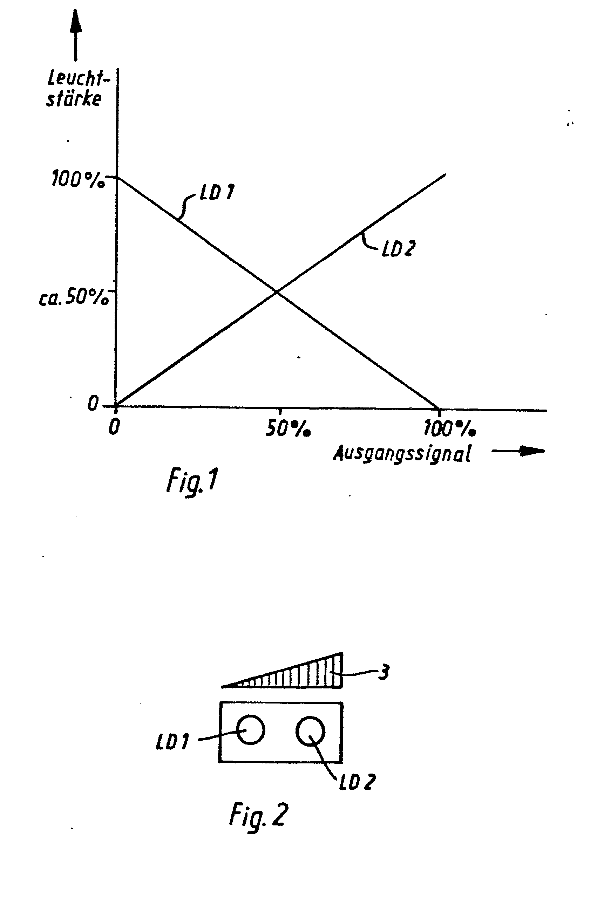

In dem in Fig.1 dargestellten Diagramm ist auf der einen Koordinate die Leuchtstärke oder Helligkeit in Prozent und auf der anderen Koordinate das am Ausgang eines Verstärkers anliegende Signal ebenfalls in Prozent vom Sollwert angegeben. Die Leuchtdiode LD1 ist, wie später noch beschrieben wird, so geschaltet, daß sie ihre größte Leuchtstärke bei 0% Ausgangssignal erreicht, während sie bei bei einem am Ausgang anliegenden Signal von 100% dunkel ist. Die Leuchtdiode LD2 ist so geschaltet, daß sie ein umgekehrtes Verhalten zeigt; sie ist bei einem am Ausgang anliegenden Signal von 0% dunkel, während sie bei einem am Ausgang anliegenden Signal von 100% ihre größte Leuchtstärke aufweist. Wenn also am Ausgang kein Signal anliegt, so leuchtet die Leuchtdiode LD1 voll auf, d.h. sie leuchtet mit der größten Leuchtstärke, während die Leuchtdiode LD2 nicht aufleuchtet, also dunkel bleibt. Je größer das am Ausgang liegende Signal ist, desto mehr nimmt die Leuchtstärke der Leuchtdiode LD1 ab und desto mehr nimmt die Leuchtstärke der Leuchtdiode LD2 zu, bis bei einem am Ausgang anliegenden Signalwert von 50% beide Leuchtidoden LD1 und LD2 mit gleicher Leuchtstärke aufleuchten. Steigt die Größe des am Ausgang anliegenden Signales über 50% vom Sollwert an, so nimmt die Leuchtstärke der Leuchtdiode LD1 immer mehr ab, bis sie bei Erreichen eines Ausgangssignals von 100% nicht mehr aufleuchtet, während die Leuchtstärke der Leuchtdiode LD2 immer mehr zunimmt, bis sie bei Erreichen eines am Ausgang anliegenden Signals von 100% ihre größte Leuchtstärke aufweist. Es kann dadurch auch sehr leicht zwischen den einzelnen Kriterien des Anliegens einer bestimmten Höhe des am Ausgang anliegenden Signals unterschieden werden. Leuchtet die Leuchtdiode LD1 hell und die Leuchtdiode LD2 bleibt dunkel, so liegt am Ausgang eines Verstärkers keine Signalspannung an. Ist die Leuchtstärke der beiden Leuchtdioden LD1 und LD2 gleich stark, so liegt am Ausgang eines Verstärkers etwa 50% der Signalsollspannung an. Leuchtet die Leuchtdiode LD1 aber nicht, während die Leuchtdiode LD2 in voller Leuchtstärke aufleuchtet, liegt am Verstärkerausgang 100% der Signalsollspannung an. Dasselbe Verhalten der Leuchtdioden LD1 und LD2 ergibt sich auch bei Werten des Ausgangssignals, die zwischen 0% und 50% der Ausgangssignalspannung liegen; dann leuchtet die Leuchtdiode LD1 deutlich erkennbar heller auf als die Leuchtdiode LD2. Ebenso verhält es sich beim Anliegen von Werten des Ausgangssignal am Verstärkerausgang von 50% bis 100% der Ausgangssignalspannung, mit dem Unterschied, daß dann die Leuchtdiode LD2 deutlich erkennbar heller aufleuchtet als die Leuchtdiode LD1, so daß auch eine Schätzung der Höhe der Ausgangssignalspannung am Verstärkerausgang in den Zwischenbereichen von 0% bis 50% und 50% bis 100% aufgrund der Anzeige der Leuchtstärkenunterschiede zwischen den Leuchtdioden LD1 und LD2 wesentlich genauer durchgeführt werden kann.

Wie aus der Prinzipdarstellung nach Fig. 2 ersichtlich ist, kann man auf dem Gehäuse eines technischen Gerätes, in dem eine solche Anzeige untergebracht ist, einen Schwellpfeil 3 über den beiden nebeneinander liegenden Leuchtdioden LD1 und LD2 anordnen, der das Ansteigen des am Verstärkerausgang anliegenden Ausgangssignals in Abhängigkeit den unter dem Schwellpfeil 3 angeordneten Leuchtdioden LD1 und LD2 symbolisiert. In Beziehung zu dem angeordneten Schwellpfeil 3 sieht es dann so aus, daß nur eine kleine Ausgangssignalspannung (oder keine) am Verstärkerausgang anliegt, wenn nur die Leuchtdiode LD1 unter der Spitze des Schwellpfeiles 3 aufleuchtet, während die Leuchtdiode LD2 vollkommen dunkel ist. Analog dazu ist es beim Anliegen der vollen Signalspannung am Verstärkerausgang umgekehrt, dann leuchtet unter der breitesten Stelle des Schwellpfeiles 3 nur die Leuchtdiode LD2 auf, während die unter der Spitze des Schwellpfeiles 3 angeordnete Leuchtdiode LD1 dunkel ist.

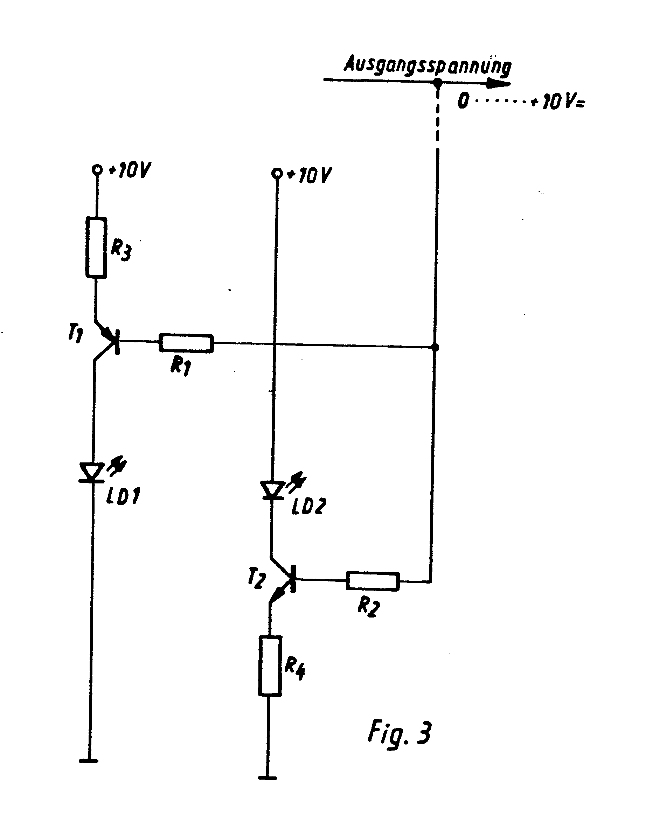

In Fig. 3 ist die Schaltungsanordnung der Leuchtdioden LD1 und LD2 zwischen dem +Ausgang eines Verstärkers und Masse angegeben. Die Leuchtdiode LD1 ist über einen Widerstand $R_1$, der zwischen dem +Ausgang des Verstärkers und der Basis eines pnp-Transistors $T_1$ liegt, mit der Anoden-Seite mit dem Kollektor des Transistors $T_1$ verbunden, während die Kathoden-Seite der Leuchtdiode LD1 an Masse liegt. Der Emitter des pnp-Transistors $T_1$ liegt über einen Widerstand $R_3$ an +10V. Die Leuchtdiode LD2 ist über einen Widerstand $R_2$, der zwischen dem +Ausgang des Verstärkers und der Basis eines npn-Transistors $T_2$ liegt, mit der Kathoden-Seite mit dem Kollektor des Transistors $T_2$ verbunden, während die Anoden-Seite der Leuchtdiode LD2 an +10V liegt. Der Emitter des npn-Transistors $T_2$ ist über einen Widerstand $R_4$ mit Masse verbunden.

Die zwischen Masse und Ausgang des Verstärkers liegende Spannung (0 bis +10V) steuert die beiden gegenläufig geschalteten bzw. arbeitenden Emitterfolger an, wodurch die Leuchtdioden LD1 und LD2 das bisher beschriebene Verhalten zeigen.

## Patentansprüche

1. Analoge Ausgangssignalanzeige, insbesondere für Regler, unter Verwendung von Leuchtdioden, dadurch gekennzeichnet, daß zwei nebeneinander angeordnete Leuchtdioden (LD1 und LD2) analog zum anzuzeigenden Ausgangssignal gegenläufig angesteuert sind.

2. Analoge Ausgangssignalanzeige nach Anspruch 1, dadurch gekennzeichnet, daß bei Nichtanliegen einer Ausgangssignalspannung am Ausgang eines Verstärkers die erste Leuchtdiode (LD1) ihre größte Leuchtstärke aufweist, während die zweite Leuchtdiode (LD2) dunkel ist, bei Anliegen der halben Ausgangssignalspannung am Ausgang eines Verstärkers beide Leuchtdioden (LD1, LD2) mit verminderter Leuchtstärke aufleuchten und bei Anliegen der vollen Ausgangssignalspannung am Ausgang eines Verstärkers die erste Leuchtdiode (LD1) dunkel ist, während die zweite Leuchtdiode (LD2) ihre größte Leuchtstärke aufweist.

3. Schaltungsanorndung zur Durchführung der analogen Ausgangssignalanzeige nach einem der Ansprüche 1 oder 2, dadurch gekennzeichnet, daß die eine Leuchtdiode (LD1) über einen Widerstand ($R_1$), der zwischen dem +Ausgang eines Verstärkers und der Basis eines pnp-Transistors ($T_1$) liegt, mit der Anodenseite mit dem Kollektor des Transistors ($T_1$) verbunden ist und die Kathodenseite der Leuchtdiode (LD1) an Masse liegt und der Emitter des Transistors ($T_1$) über einen Widerstand ($R_3$) an einer +Spannung (+10V) liegt, während die andere Leuchtdiode (LD2) über einen Widerstand ($R_2$), der zwischen dem +Ausgang des Verstärkers und der Basis eines npn-Transistors ($T_2$) liegt, mit der Kathodenseite mit dem Kollektor des Transistors ($T_2$) verbunden ist und die Anodenseite der Leuchtdiode (LD2) an einer +Spannung (+10V) liegt, während der Emitter des Transistors ($T_2$) über einen Widerstand ($R_4$) mit Masse verbunden ist.

0061142

Leucht-
stärke
100%
ca. 50%
0
LD 1
LD 2
0
50%
100%
Ausgangssignal

Fig. 1

3
LD 1
LD 2

Fig. 2

Ausgangsspannung
0 ······ +10V=
+10V
+10V
R3
T1
R1
LD1
LD2
T2
R2
R4

Fig. 3